# FASCICULE DE BREVET EUROPEEN

(11) **EP 0 599 682 B1**
(45) Date de publication et mention de la délivrance du brevet: **08.10.1997**
(21) Numéro de dépôt: 93402693.1
(22) Date de dépôt: 03.11.1993
(51) Int. Cl.: B01J 4/00, C23C 16/52, G01N 9/00, F17C 13/02

(54) **Procédé d'alimentation gazeuse notamment en diborane et silane**
Beschickungsverfahren für Gase, insbesonders für Diborane und Silane
Gaseous feeding process, paricularly for diborane and silane

(30) Priorité: 20.11.1992 FR 9213956
(43) Date de publication de la demande: 01.06.1994
(73) Titulaire: L'AIR LIQUIDE, SOCIETE ANONYME POUR L'ETUDE ET L'EXPLOITATION DES PROCEDES GEORGES CLAUDE, 75321 Paris Cédex 07 (FR)
(72) Inventeur: Bryselbout, Francis, F-78320 Le Mesnil Saint Denis (FR)
(74) Mandataire: Vesin, Jacques

(56) Documents cités:
- GB-A- 2 124 767
- US-A- 4 369 031
- PATENT ABSTRACTS OF JAPAN vol. 016, no. 126 (C-0923) 31 Mars 1992 & JP-A-3 290 395 (NEC CORPORATION) 20 Décembre 1991

## Description

L'invention concerne l'alimentation en gaz, notamment en mélange gazeux essentiellement à base de diborane (B₂H₆) et de silane (SiH₄, destiné à un réacteur d'élaboration de couches de verre à base de bore, phosphate, silicate (BPSG) (〈〈 Boro-phospho-silicate glass 〉〉) à partir d'un stockage initial de B₂H₆/SiH₄ dans des proportions déterminées.

On sait que ce type de mélange se modifie dans le temps sous l'effet de la tendance du diborane (B₂H₆)à se dégrader en boranes supérieurs, tels le tétraborane (B₄H₁₀) pentaborane 11 (B₅H₁₁) notamment, qui d'une part libèrent de l'hydrogène (H₂), d'autre part se transforment parfois en forme liquide ou même solide non transférée avec le débit gazeux. Il en résulte qu'à partir d'un stockage parfaitement convenable, le mélange transféré au réacteur présente des défauts de composition, notamment une plus faible teneur en bore, qui le rendent impropre à l'élaboration correcte de couche de verre du type BPSG.

C'est la raison pour laquelle, actuellement, on effectue des analyses du mélange gazeux transféré vers le réacteur, et cela par chromatographie qui est une méthode discontinue, peu pratique, et qui nécessite des réétalonnages fréquents.

Le document GB-A-2,124,767 a décrit une méthode de détection du moment où un produit hydrocarbure passant à l'intérieur d'une canalisation change : ce document illustre l'application typique où différents hydrocarbures sont pompés le long d'une même canalisation entre une raffinerie et un site de stockages. L'envoi d'un hydrocarbure donné dans le stockage qui lui correspond dépend donc d'une détermination précise du moment où l'hydrocarbure qui circule dans la canalisation a été modifié en amont.

La procédure décrite dans ce document est alors discontinue et parfaitement qualitative : une antenne est plongée à l'intérieur d'un produit fluide, et portée à une fréquence qui produit une résonance dans ce fluide particulier. Quand un second fluide, différent du premier, est présent à l'intérieur de la canalisation, l'antenne n'est alors plus en situation de résonance. Le moment de changement de fluide dans la canalisation ayant ainsi été détecté, l'antenne est alors portée au pic de résonance correpondant à ce nouveau fluide, et ainsi prête à détecter un nouveau changement de composition dans la canalisation (fluide N° 3, etc...).

La présente invention vise à perfectionner les procédés d'alimentation en gaz, dont un constituant est susceptible de décomposer en entraînant une variation de la masse volumique du gaz, permettant de façon fiable, simple et continue, d'assurer une composition constante du gaz parvenant au point utilisateur, en particulier en le constituant susceptible de se décomposer.

Ces objectifs sont atteints, selon l'invention, par mesure en continu de la masse volumique du gaz ou mélange, et détermination subséquente de la variation de composition, en particulier de la teneur en B₂H₆ de façon à, le cas échéant, modifier les conditions d'alimentation gazeuse en gaz ou en mélange, notamment (B₂H₆) (SiH₄) (H₂). La mesure de la masse volumique s'effectue de préférence au moyen d'un densimètre à gaz, du genre à tube vibrant sous l'effet d'une excitation électrique, la fréquence de vibration dépendant de la masse volumique du mélange traversant ledit tube vibrant, et en traitant l'information fréquence, en fonction d'autres informations telles la pression et la température du mélange gazeux, pour déterminer en continu la valeur de la masse volumique dudit mélange.

De la sorte l'information de masse volumique peut être utilisée pour modifier les conditions d'alimentation, en particulier en mélange B₂H₆-SiH₄, par exemple en asservissant le débit de gaz ou du mélange gazeux et/ou en y adjoignant un débit correcteur additionnel, par exemple à base de diborane (B₂H₆), le complément étant un gaz inerte.

L'invention concerne également une installation de mise en oeuvre de ce procédé.

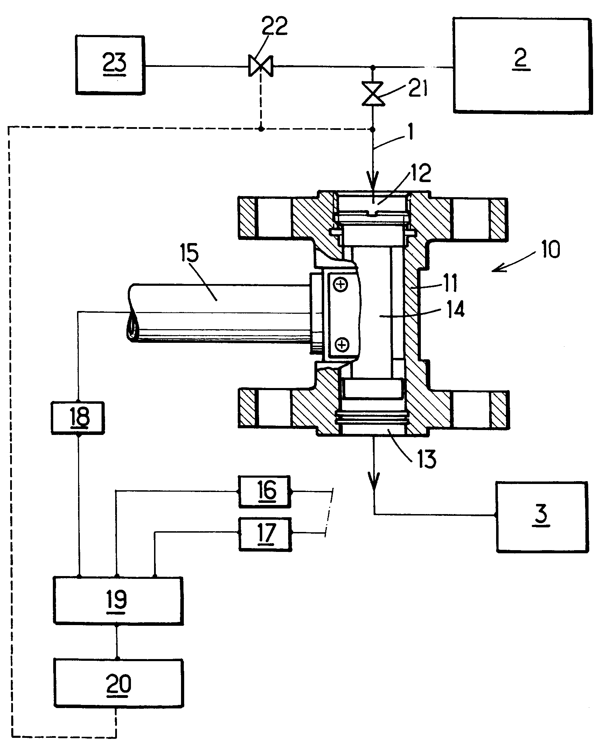

On détaille ci-après une réalisation d'une telle installation en référence au dessin annexé, auquel on se réfère maintenant.

Une conduite 1 reliant un réservoir de stockage 2 contenant un mélange gazeux initialement constitué de diborane et de silane, à un réacteur d'utilisation 3. Sur la conduite 1 est monté un densimètre à gaz 10 avec une armature 11 incorporant entre une admission 12 et une sortie 13 un tube vibrant 14 sous l'effet d'une excitation électrique via un conducteur 15, le tout associé à un capteur de pression 16 et à un capteur de température 17. La fréquence de vibration du tube 14 ressort d'un fréquencemètre 18, dont l'information de fréquence et celles de pression et de température sont traitées dans une unité de traitement 19 pour afficher une valeur de masse volumique, et le cas échéant être en outre transférée dans un comparateur 20 de valeur affichée pour modifier l'ouverture d'une vanne 21 sur la conduite 1, et/ou ouvrir plus ou moins une vanne 22 de débit additionnel de diborane à partir d'un stockage auxiliaire 23 d'un mélange de diborane et de gaz neutre (azote, argon).

A titre d'exemple, on donne sur le tableau ci-après pour un mélange B₂H₆/SiH₄/H₂ la teneur en hydrogène (%H₂) déterminée à partir des relevés de pression (bar), de température (°C), de la fréquence mesurée (µs) déterminant une densité permettant alors de calculer la teneur en hydrogène.

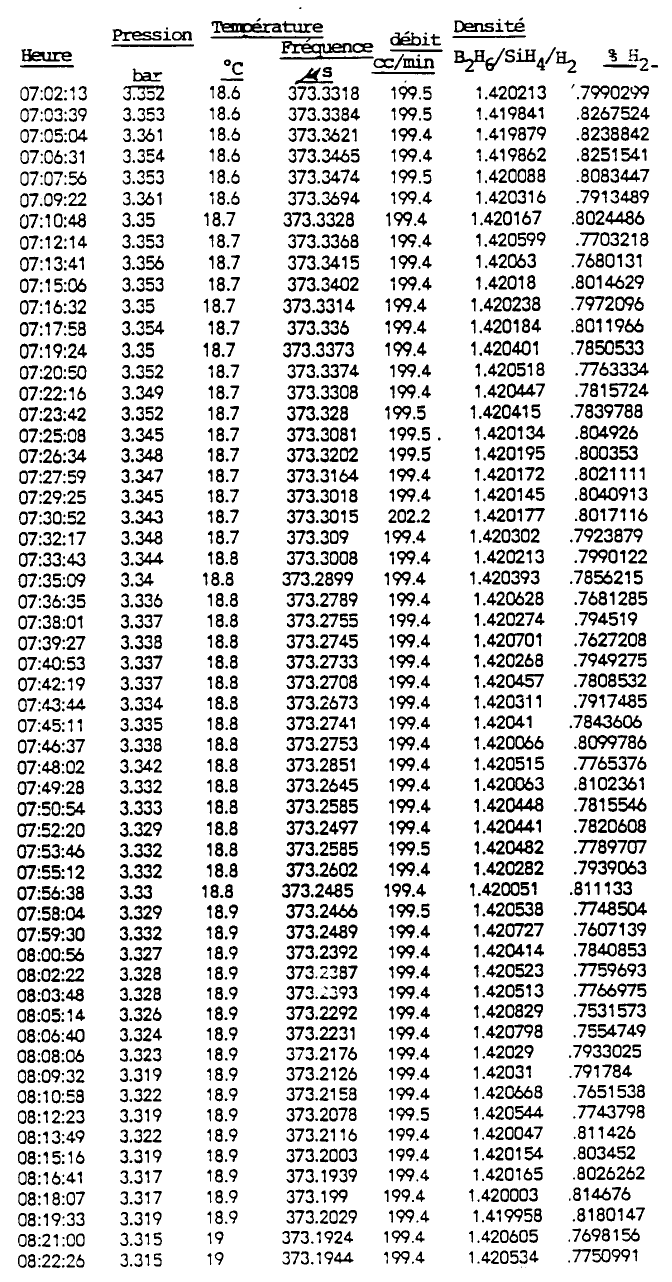

## Revendications

1. Procédé d'alimentation en gaz, dont un constituant est susceptible de se décomposer en entraînant une variation de la masse volumique du gaz, selon lequel on procède aux étapes suivantes :
i) on mesure en continu la masse volumique du gaz ;
ii) on modifie, le cas échéant, les conditions d'alimentation en ledit gaz, si une variation de la masse volumique du gaz a été détectée.

2. Procédé selon la revendication 1, caractérisé en ce que la mesure de la masse volumique du gaz s'effectue au moyen d'un densimètre à gaz (10), du genre à tube vibrant(14) sous l'effet d'une excitation électrique, de la façon suivante :
- on fait passer ledit gaz au travers (12-13) du tube vibrant (14) ;
- on mesure (18) la fréquence de vibration du tube vibrant ;
- on traite (19) la mesure de fréquence ainsi obtenue, dans une unité de traitement, pour obtenir ladite mesure de masse volumique du gaz.

3. Procédé selon la revendication 1 ou 2, caractérisé en ce que ledit constituant susceptible de se décomposer est le diborane (B₂H₆).

4. Procédé selon l'une des revendications 1 à 3, caractérisé en ce que ledit gaz comporte un mélange de diborane (B₂H₆) et silane (SiH₄).

5. Procédé selon l'une des revendications 1 à 4, caractérisé en ce que ledit constituant susceptible de se décomposer se dégrade en boranes supérieurs tels le tetraborane (B₄H₁₀) et le pentaborane 11 (B₅H₁₁).

6. Procédé d'alimentation en mélange gazeux essentiellement à base de diborane (B₂H₆) et de silane (SiH₄), d'un réacteur d'élaboration de couches de verre à base de bore, phosphate, silicate (BPSG- 〈〈Borophospho silicate glass 〉〉) à partir d'un stockage initial de B₂H₆/SiH₄, dans des proportions déterminées, caractérisé par la mise en oeuvre des étapes suivantes :
i) on mesure en continu la masse volumique du mélange gazeux ;
ii) on détermine de façon subséquente la teneur en B₂H₆ du mélange gazeux, de façon à, le cas échéant, modifier les conditions d'alimentation gazeuse du réacteur.

7. Procédé selon la revendication 6, caractérisé en ce que ladite mesure de masse volumique s'effectue de la façon suivante :
- on fait passer ledit mélange gazeux au travers d'un tube vibrant sous l'effet d'une excitation électrique ;
- on mesure la fréquence de vibration du tube vibrant ;
- on traite l'information de fréquence ainsi obtenue dans une unité de traitement, afin de déterminer ladite masse volumique.

8. Procédé selon la revendication 7, caractérisé en ce que ladite unité de traitement détermine la masse volumique du mélange gazeux à partir de la mesure de fréquence et en fonction d'autres informations telles la pression et la température du mélange gazeux.

9. Procédé selon l'une des revendications 6 à 8, caractérisé en ce que l'on modifie les conditions d'alimentation gazeuse du réacteur en asservissant le débit de mélange gazeux et/ou en y adjoignant un débit correcteur additionnel d'un gaz auxiliaire à base de diborane (B₂H₆).

10. Installation d'alimentation d'un réacteur (3) en gaz à partir d'un stockage (2), caractérisée en ce qu'elle comprend, sur un conduit (1) d'alimentation s'étendant entre le stockage et le réacteur, les éléments suivants :
1) un densimètre (10) à gaz du genre à tube vibrant (14) sous l'effet d'une excitation électrique (15), dont la fréquence de vibration dépend de la masse volumique du mélange gazeux traversant ledit tube vibrant ;
2) une unité (19) de traitement d'information, apte, en traitant la mesure de fréquence de vibration du densimètre à gaz, à déterminer en continu la valeur de la masse volumique d'un mélange gazeux et à déduire de cette valeur de la masse volumique du mélange la teneur du mélange gazeux en un constituant du mélange,
3) des moyens (21, 22), aptes à modifier les conditions d'alimentation gazeuse du réacteur, lorsque une variation de la masse volumique du gaz a été détectée par l'unité de traitement d'information.

11. Installation selon la revendication 10, caractérisée en ce qu'elle comprend des capteurs de pression et de température du mélange gazeux.

12. Installation selon l'une des revendication 10 ou 11, caractérisée en ce que les dits moyens comprennent une boucle de réaction apte à agir sur le débit (21) de mélange gazeux et/ou sur un débit (22) additionnel d'un gaz auxiliaire à base dudit constituant, pour réduire tout écart de la valeur de la teneur du mélange gazeux en ledit constituant déterminée par l'unité de traitement par rapport à une valeur de consigne.

## Claims

1. Process for supplying a gas, a constituent of which is liable to decompose resulting in a variation in density, which proceeds in the following stages :
(i) the density of the gas is measured continuously;
(ii) where necessary, the conditions for supplying the said gas are modified if a variation in the density of the gas has been detected.

2. Process according to claim 1, characterized in that the density of the gas is measured by means of a gas densimeter (10) of the type having a tube (14) vibrating under the effect of an electrical excitation, in the following manner :
- the said gas is passed through (12-13) the vibrating tube (14);
- the vibration frequency of the vibrating tube is measured (18);
- the frequency measurement thus obtained is processed (19) so as to obtain the said measurement of the density of the gas.

3. Process according to claim 1 or 2, characterized in that the said constituent which is liable to decompose is diborane (B₂H₆).

4. Process according to one of claims 1 to 3, characterized in that the said gas comprises a mixture of diborane (B₂H₆) and silane (SiH₄).

5. Process according to one of claims 1 to 4, characterized in that the said constituent which is liable to decompose degrades into higher boranes such as tetraborane (B₄H₁₀) and pentaborane 11 (B₅H₁₁).

6. Process for supplying a reactor for preparing glass sheets based on boron, phosphate and silicate (BPSG - "borophosphosilicate glass") with a gaseous mixture substantially based on diborane (B₂H₆) and silane (SiH₄), from an initial store of B₂H₆/SiH₄, in definite proportions, characterized in that it is put into practice in the following stages :
i) the density of the gaseous mixture is measured continuously;
ii) the B₂H₆ content of the gaseous mixture is subsequently determined so as to modify, where necessary, the conditions for supplying gas to the reactor.

7. Process according to claim 6, characterized in that the said density measurement is carried out in the following manner :
- the said gas is passed through a tube vibrating under the effect of an electric excitation;
- the vibration frequency of the vibrating tube is measured;
- the frequency data thus obtained are processed in a processing unit so as to determine the said density.

8. Process according to claim 7, characterized in that the said processing unit determines the density of the gaseous mixture from the frequency measurement and in relation to other information such as the pressure and temperature of the gaseous mixture.

9. Process according to one of claims 6 to 8, characterized in that the conditions under which the reactor is supplied with gas are modified by regulating the gas supply to the reactor and/or by introducing an additional correcting flow of an auxiliary gas based on diborane (B₂H₆).

10. Installation for supplying a reactor (3) with gas from a storage vessel (2), characterized in that it comprises, on a supply pipe (1) extending between the storage vessel and the reactor, the following components :
(1) a gas densimeter (10) of the type having a tube (14) vibrating under the effect of an electric excitation (15), the vibration frequency of which depends on the density of the gaseous mixture passing through the said vibrating tube;
(2) a data processing unit (19) which is able, by processing the vibration frequency of the gas densimeter, to determine continuously the value of the density of a gaseous mixture and of deducing from this value for the density of the mixture the concentration of a constituent of the mixture in the gaseous mixture.
(3) means (21, 22), capable of modifying the conditions for supplying the gaseous mixture to the reactor, when a variation in the density of the gas has been detected by the data processing unit.

11. Installation according to claim 10, characterized in that it comprises pressure and temperature sensors for the gaseous mixture.

12. Installation according to either of claims 10 or 11, characterized in that the said means comprise a reaction loop capable of acting on the flow (21) of the gaseous mixture and/or on an additional flow (22) of an auxiliary gas based on the said constituent, so as to reduce any deviation of the value of the concentration of the said constituent in the gaseous mixture determined by the processing unit, with respect to a set value.

## Patentansprüche

1. Verfahren zur Versorgung mit Gas, dessen einer Bestandteil dazu neigt, sich unter Änderung der Gasdichte zu zersetzen, gemäß welchem in folgenden Schritten verfahren wird:
i) es wird kontinuierlich die Dichte des Gases gemessen;
ii) es werden gegebenenfalls die Bedingungen der Versorgung mit dem genannten Gas modifiziert, wenn eine Änderung der Gasdichte ermittelt wurde.

2. Verfahren nach Anspruch 1, dadurch gekennzeichnet, daß die Messung der Gasdichte mittels eines Gas-Densimeters (10), welches von der Art einer unter der Einwirkung einer elektrischen Anregung vibrierenden Röhre (14) ist, in folgender Weise ausgeführt wird:
- es wird das genannte Gas durch die vibrierende Röhre (14) hindurch (12-13) geleitet;
- es wird die Vibrationsfrequenz der vibrierenden Röhre gemessen (18);
- es wird der auf diese Weise erhaltene Frequenz-Meßwert in einer Verarbeitungseinheit verarbeitet (19), um den Meßwert der genannten Gasdichte zu erhalten.

3. Verfahren nach Anspruch 1 oder 2, dadurch gekennzeichnet, daß der genannte zur Zersetzung neigende Bestandteil das Diboran (B₂H₆) ist.

4. Verfahren nach einem der Ansprüche 1 bis 3, dadurch gekennzeichnet, daß das genannte Gas ein Gemisch aus Diboran (B₂H₆) und Silan (SiH₄) umfaßt.

5. Verfahren nach einem der Ansprüche 1 bis 4, dadurch gekennzeichnet, daß der genannte zur Zersetzung neigende Bestandteil sich zu höheren Boranen, wie Tetraboran (B₄H₁₀) und Pentaboran 11 (B₅H₁₁), abbaut.

6. Verfahren zur Versorgung eines Reaktors zur Herstellung von Glasschichten auf Basis von Bor, Phosphat, Silikat (BPSG - "Boro-phospho-silikat-Glas") mit Gasgemischen insbesondere auf Basis von Diboran (B₂H₆) und Silan (SiH₄) aus einer anfänglichen Speicherung von B₂H₆/SiH₄ in bestimmten Verhältnissen, dadurch gekennzeichnet, daß die folgenden Schritte ausgeführt werden:
i) es wird kontinuierlich die Gasdichte des Gasgemisches gemessen;
ii) es wird auf folgende Weise der Gehalt des Gasgemisches an B₂H₆ bestimmt, um gegebenenfalls die Bedingungen der Gasversorgung des Reaktors zu modifizieren.

7. Verfahren nach Anspruch 6, dadurch gekennzeichnet, daß die genannte Dichte-Messung in folgender Weise ausgeführt wird:
- es wird das genannte Gasgemisch durch eine unter Einwirkung einer elektrischen Anregung vibrierende Röhre hindurch geleitet;
- es wird die Vibrationsfrequenz der vibrierenden Röhre gemessen;
- es wird die auf diese Weise erhaltene Frequenz-Information in einer Verarbeitungseinheit verarbeitet, um die genannte Dichte zu ermitteln.

8. Verfahren nach Anspruch 7, dadurch gekennzeichnet, daß die genannte Verarbeitungseinheit die Dichte des Gasgemisches aus der Frequenzmessung und in Abhängigkeit von anderen Informationen, wie Druck und Temperatur des Gasgemisches, ermittelt.

9. Verfahren nach einem der Ansprüche 6 bis 8, dadurch gekennzeichnet, daß die Bedingungen der Gasversorgung des Reaktors modifiziert werden, indem der Gasgemisch-Durchsatz reguliert wird und/oder dort ein Hilfsgas auf Basis von Diboran (B₂H₆) als zusätzliches Durchsatz-Korrektiv hinzugefügt wird.

10. Vorrichtung zur Versorgung eines Reaktors (3) mit Gas aus einer Speicherung (2), dadurch gekennzeichnet, daß sie die folgenden Elemente auf einer Versorgungsleitung (1), die sich zwischen der Speicherung und dem Reaktor erstreckt, umfaßt:
1) ein Gas-Densimeter (10) von der Art einer unter der Einwirkung einer elektrischen Anregung (15) vibrierenden Röhre (14), deren Vibrationsfrequenz von der Dichte des Gasgemisches abhängt, das die genannte vibrierende Röhre durchströmt;
2) eine Einheit (19) zur Informationsverarbeitung, die geeignet ist, durch die Verarbeitung des Meßwerts der Vibrationsfrequenz vom Gas-Densimeter kontinuierlich den Dichtewert eines Gasgemisches zu ermitteln und von diesem Gemisch-Dichtewert den Gehalt des Gasgemisches an einem Gemisch-Bestandteil abzuleiten;
3) Mittel (21, 22), die geeignet sind, die Bedingungen der Gasversorgung des Reaktors zu modifizieren, wenn eine Veränderung der Gasdichte von der Datenverarbeitungseinheit ermittelt worden ist.

11. Vorrichtung nach Anspruch 10, dadurch gekennzeichnet, daß sie Meßfühler für Druck und Temperatur des Gasgemisches umfaßt.

12. Vorrichtung nach einem der Ansprüche 10 oder 11, dadurch gekennzeichnet, daß die genannten Mittel eine Reaktionsschleife umfassen, die geeignet ist, auf den Durchlaß (21) für das Gasgemisch und/oder auf einen zusätzlichen Durchlaß (22) für ein Hilfsgas auf Basis des genannten Bestandteils einzuwirken, um jede Abweichung des Wertes des Gasgemisch-Gehalts an genanntem Bestandteil, der von der Verarbeitungseinheit durch Vergleich mit einem Sollwert ermittelt wurde, zu verringern.
